# EUROPEAN PATENT SPECIFICATION

(11) **EP 1 153 894 B1**
(45) Date of publication and mention of the grant of the patent: **15.10.2003**
(21) Application number: 01304085.2
(22) Date of filing: 04.05.2001
(51) Int. Cl.: C03B 19/14, C23C 16/44

(54) **Manufacturing method of optical waveguide**
Verfahren zur Herstellung eines optischen Wellenleiters
Procédé de fabrication d'un guide d'ondes optiques

(30) Priority: 12.05.2000 JP 2000139837
(43) Date of publication of application: 14.11.2001
(73) Proprietor: The Furukawa Electric Co., Ltd., Tokyo 100-8322 (JP)
(72) Inventor: Komatsu, Takuya, Chiyoda-ku Tokyo 100-8322 (JP); Kashihara, Kazuhisa, Chiyoda-ku Tokyo 100-8322 (JP); Nara, Kazutaka, Chiyoda-ku Tokyo 100-8322 (JP)
(74) Representative: Dealtry, Brian

(56) References cited:
- PATENT ABSTRACTS OF JAPAN vol. 98, no. 5, 30 April 1998 (1998-04-30) & JP 10 017331 A (FURUKAWA ELECTRIC CO LTD), 20 January 1998 (1998-01-20)
- PATENT ABSTRACTS OF JAPAN vol. 1997, no. 11, 28 November 1997 (1997-11-28) & JP 09 178969 A (FURUKAWA ELECTRIC CO LTD), 11 July 1997 (1997-07-11)
- PATENT ABSTRACTS OF JAPAN vol. 97, no. 2, 28 February 1997 (1997-02-28) & JP 08 262252 A (FURUKAWA ELECTRIC CO LTD), 11 October 1996 (1996-10-11)
- PATENT ABSTRACTS OF JAPAN vol. 18, no. 400, 26 July 1994 (1994-07-26) & JP 06 115959 A (FURUKAWA ELECTRIC CO LTD), 26 April 1994 (1994-04-26)
- PATENT ABSTRACTS OF JAPAN vol. 1999, no. 13, 30 November 1999 (1999-11-30) & JP 11 209131 A (SUMITOMO ELECTRIC IND LTD), 3 August 1999 (1999-08-03)

## Description

### FIELD OF THE INVENTION

The present invention relates to a manufacturing method of an optical waveguide using a frame hydrolysis deposition method.

### BACKGROUND OF THE INVENTION

Optical waveguides of various constructional modes formed on a substrate are used in an optical communication field. The optical waveguides of this kind have various functions of optical multiplexing/demultiplexing, etc. according to these waveguide constructions.

There is a method for forming an optical waveguide by depositing glass particulates on the substrate using the FHD (Flame Hydrolysis Deposition) method as a manufacturing method of the optical waveguide.

### SUMMARY OF THE INVENTION

The present invention provides a manufacturing method of an optical waveguide having the following construction in one aspect. Namely, the invention resides in a manufacturing method of an optical waveguide in which a hydrolysis reaction of raw material gas of glass is caused within an oxygen-hydrogen flame by flowing the raw material gas, oxygen gas and hydrogen gas from a burner, and the optical waveguide is formed by depositing glass particulates on a substrate;
the manufacturing method comprising the steps of:
injecting the oxygen-hydrogen flame toward an optical waveguide forming area in a slanting direction on the substrate;
arranging an exhaust pipe on the discharging side of a flow injected to this optical waveguide forming area; and
depositing glass particulates in the optical waveguide forming area while surplus glass particulates unattached to the optical waveguide forming area are sucked and exhausted by the exhaust pipe;
characterized in that the surplus glass particulates are sucked and exhausted by the exhaust pipe by inclining a suction port side of the exhaust pipe by an angle within a range from 5° to 30° with respect to a face of the substrate.

A prior art method comprising the steps of the preamble of claim 1 of the present application is known from JP 10 017 331 A.

### BRIEF DESCRIPTION OF THE DRAWINGS

Exemplify embodiments of the invention will now be described in conjunction with drawings in which:
Fig. 1 is one process view of a manufacturing method of an optical waveguide in accordance with one embodiment of the present invention.
Figs. 2A, 2B and 2C are explanatory views respectively showing a flow of surplus glass particulates and a depositing situation of the surplus glass particulates into an exhaust pipe for sucking and exhausting the surplus glass particulates when the angle of a suction port side of the exhaust pipe is changed at a manufacturing time of the optical waveguide using the flame hydrolysis deposition method.
Fig. 3 is a graph of experimental results showing a dispersion width of a film thickness distribution in an optical waveguide forming area and a changing situation of a defect number of the optical waveguide when the glass particulates are deposited in the optical waveguide forming area by changing the angle of the suction port side of the exhaust pipe using the flame hydrolysis deposition method.
Fig. 4 is an explanatory view showing one process of a conventional manufacturing method of the optical waveguide using the flame hydrolysis deposition method.

### DESCRIPTION OF THE PREFERRED EMBODIMENTS

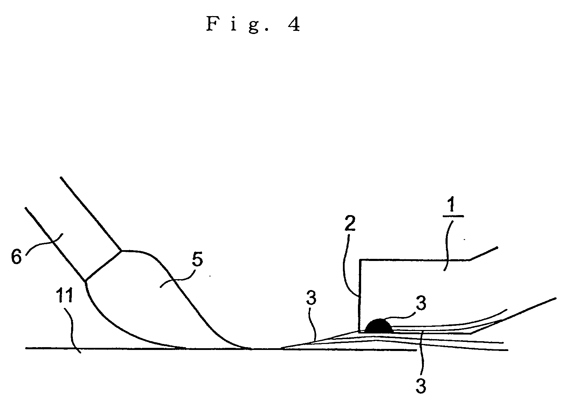

When an optical waveguide is manufactured by applying the flame hydrolysis deposition method, for example, as shown in Fig. 4, raw material gas of glass, oxygen gas and hydrogen gas flow from a burner 6, and a hydrolysis reaction of the raw material gas is caused within an oxygen-hydrogen flame 5 so that lower clad glass particulates are first deposited on a substrate 11.

The oxygen-hydrogen frame 5 is injected slantingly downward toward an optical waveguide forming area on the substrate 11. An exhaust pipe 1 is arranged on the discharging side of a flow injected to this optical waveguide forming area. The side of a suction port 2 of this exhaust pipe 1 is conventionally arranged such that this suction port side is horizontal (parallel) with respect to a plane of the substrate 11. In a depositing process of the glass particulates, while surplus glass particulates 3 unattached to the optical waveguide forming area are sucked and exhausted by the exhaust pipe 1, the glass particulates are deposited in the optical waveguide forming area.

After the deposition of the lower clad glass particulates is terminated by the above process, these glass particulates are formed as glass by consolidation. Thereafter, similar to the above case, core glass particulates are deposited on the lower clad glass formed as glass. The core glass particulates are then formed as glass by consolidation. Thereafter, the core is patterned in a waveguide construction by photolithography and a reactive ion etching method. Thereafter, similar to the above case, upper clad glass particulates are deposited on the core pattern, and the optical waveguide is formed in the optical waveguide forming area by forming these upper clad glass particulates as glass. Similar to the forming process of the lower clad, the surplus glass particulates 3 are also exhausted at a depositing time of the core glass particulates and the upper clad glass particulates.

It is necessary to reliably exhaust the surplus glass particulates 3 by the exhaust pipe 1 so as to accurately form the optical waveguide as designed. However, in the conventional manufacturing method, unexhausted glass particulates 3 exist within a depositing atmosphere at any time even when the exhaust using the exhaust pipe 1 is performed. Accordingly, no sufficient exhaust of the surplus glass particulates 3 is performed.

Therefore, the unexhausted surplus glass particulates 3 are floated in the depositing atmosphere, and are attached onto the substrate 11 so that the uniformity of respective film thicknesses of the lower clad, the core and the upper clad on a face of the substrate 11 is damaged. For example, a problem exists in that the dispersion width of a film thickness distribution of the optical waveguide formed on the substrate 11 having 100 mmφ in diameter becomes a large value such as about 1.6 µm in average. The dispersion width of the film thickness distribution is defined as (maximum film thickness - minimum film thickness) of the film thickness distribution. In general, plural waveguides are collectively formed on the substrate 11 as mentioned above. Thereafter, the waveguides are divided (separated) into individual optical waveguides. However, when the uniformity of the film thicknesses is damaged as mentioned above, the film thicknesses of the respective waveguides formed on the substrate 11 are different in accordance with their arranging positions. Therefore, a size error is caused in each manufactured optical waveguide (each optical waveguide chip) so that no quality of the optical waveguide is uniformed.

In particular, an equivalent refractive index of the optical waveguide is changed by the dispersion of the film thickness distribution of a core portion of the optical waveguide. Therefore, there is a fear that characteristics of the optical waveguide are different from designed values.

Further, since a crystal and a noncrystal are formed on the substrate 11 with the surplus glass particulates 3 as a core, these crystal and noncrystal become defects and cause an increase in loss of the optical waveguide.

Further, when a depositing work is made for a long time, the surplus glass particulates 3 are deposited near the suction port 2 of the exhaust pipe 1 as shown in Fig. 4. There are also cases in which the exhaust is prevented by this deposition, and the deposited surplus glass particulates 3 drop on a film (at least one of depositing films of the lower clad, the core and the upper clad) being deposited, and cause a defect in manufacture of the optical waveguide.

The present invention provides a manufacturing method of an optical waveguide able to precisely manufacture the optical waveguide having a waveguide construction as designed, and improve yield in one aspect.

The present inventor has considered that the optical waveguide having a waveguide construction as designed can be precisely manufactured and yield can be improved by solving the above problem of the exhaust of surplus glass particulates in manufacture of the optical waveguide using the flame hydrolysis deposition method.

Therefore, the conventional manufacturing method shown in Fig. 4 is first executed and a flow of the surplus glass particulates 3 near the exhaust pipe 1 is carefully observed to solve the problem of the exhaust of the surplus glass particulates.

As a result, in the conventional manufacturing method of the optical waveguide, it has been found that a large part of the surplus glass particulates flows into the exhaust pipe, but there is also a flow of the surplus glass particulates 3 flowing outside the exhaust pipe 1.

Further, when a depositing method of the surplus glass particulates 3 near the suction port 2 of the exhaust pipe 1 is observed, it has been also found that the surplus glass particulates 3 hitting against the suction port 2 are deposited on a side of the suction port 2 of the exhaust pipe 1 so as to be sequentially grown, and finally drop onto a film being deposited.

Therefore, it has been considered that the following two points are important to precisely manufacture the optical waveguide having the waveguide construction as designed, and improve yield. Namely, (1) a first point is to perfectly guide the flow of the surplus glass particulates into the exhaust pipe, and (2) a second point is to deposit the surplus glass particulates within the exhaust pipe as much as possible and not to drop the surplus glass particulates onto the film being deposited when the surplus glass particulates guided into the exhaust pipe are deposited within the exhaust pipe.

To restrain the above defective phenomenon, the suction port side of the exhaust pipe is inclined slantingly instead of horizontally with respect to a substrate face as in the conventional case so that the flow of the surplus glass particulates can be changed. Thus, the following contents are considered.

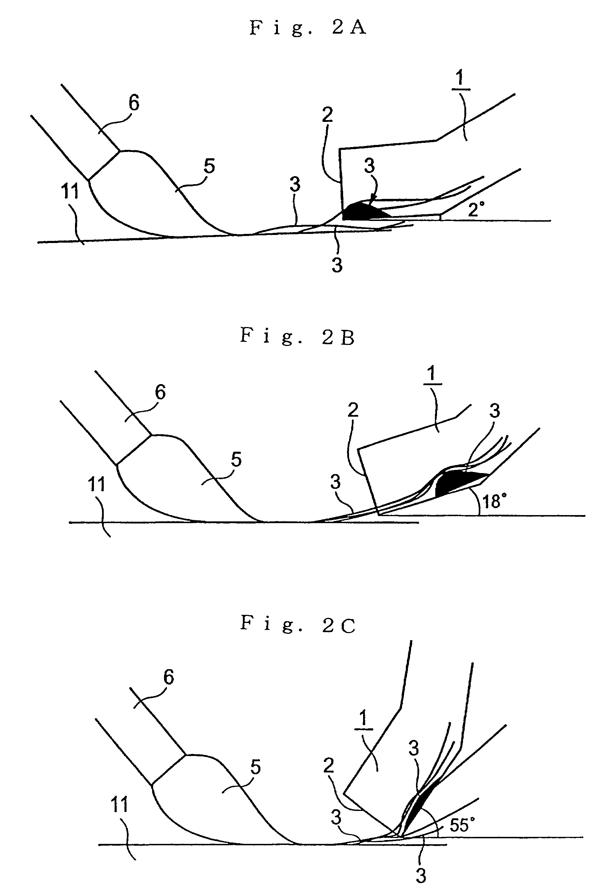

First, as shown in Fig. 2A, the side of a suction port 2 of the exhaust pipe 1 is inclined about 2° with respect to a face of the substrate 11. As a result, the flow of surplus glass particulates 3 flowing outside the exhaust pipe 1 is reduced, but a depositing position of the surplus glass particulates 3 is located on a side near the suction port 2 of the exhaust pipe 1.

Further, as shown in Fig. 2B, when the side of the suction port 2 of the exhaust pipe 1 is inclined about 18° with respect to the face of the substrate 11, there is no flow of the surplus glass particulates 3 flowing outside the exhaust pipe 1, and the depositing position of the surplus glass particulates 3 is located inside the exhaust pipe 1 instead of the side of the suction port 2 of the exhaust pipe 1.

Further, as shown in Fig. 2C, when the side of the suction port 2 of the exhaust pipe 1 is inclined about 55° with respect to the face of the substrate 11, surplus glass particulates 3 are hardly exhausted from the exhaust pipe 1. Therefore, a depositing amount of the surplus glass particulates 3 is also reduced.

Therefore, to know the above contents in further detail, the side of the suction port 2 of the exhaust pipe 1 is inclined with respect to the face of the substrate 11 by changing the inclination angle within a range from 0° to 90°, and the relation of a dispersion width of a film thickness distribution of the optical waveguide corresponding to this angle, and a defect number has been considered. The substrate 11 used in this consideration is set to a wafer having 100 mmφ in diameter, and the film thickness distribution is measured by a reflection spectrum type film thickness distribution gauge, and the defect number is calculated by visual confirmation in a wafer area.

As a result, results shown in Fig. 3 are obtained. In accordance with these results, the dispersion width of the film thickness distribution is provided as shown by a characteristic line a of Fig. 3, and the defect number is provided as shown by a characteristic line b of Fig. 3. In consideration of both the characteristic lines a and b, it has been found that suction and exhaust using the exhaust pipe 1 are performed by inclining the side of the suction port 2 of the exhaust pipe 1 by 5° to 30° with respect to the face of the substrate 11 to satisfy both conditions of reducing the dispersion width of the film thickness distribution and reducing the defect number.

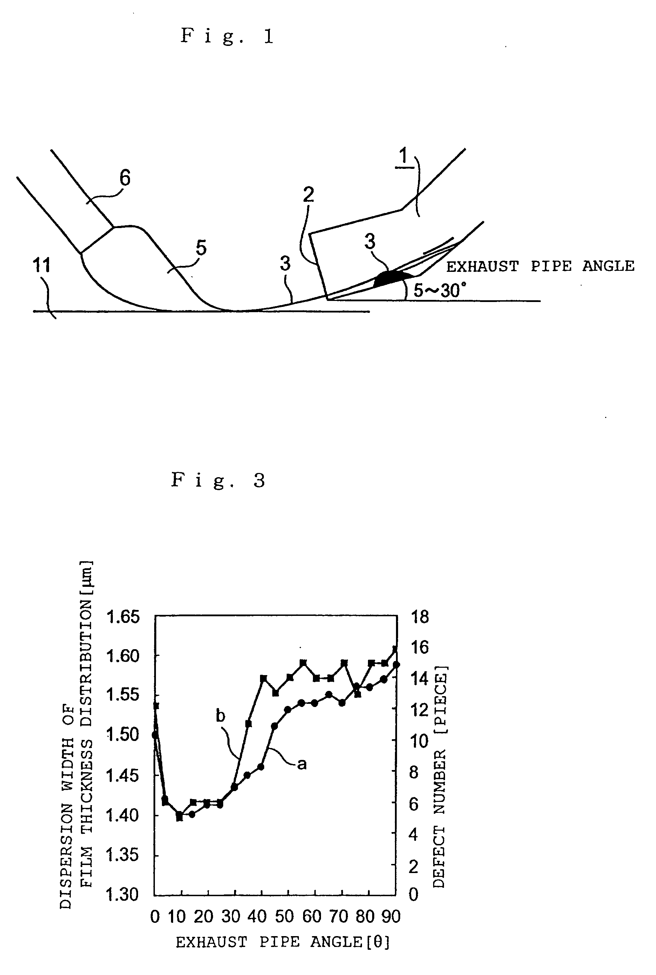

One embodiment of the invention is based on the above consideration and will next be explained concretely. In the explanation of this embodiment, the same name portions as the conventional example shown in Fig. 4 are designated by the same reference numerals, and their overlapped explanations are omitted or simplified here. Fig. 1 shows a depositing process view of glass particulates in the manufacturing method of the optical waveguide in accordance with one embodiment of the invention.

In the manufacturing method of the optical waveguide in one embodiment of the invention, a side of the suction port 2 of the exhaust pipe 1 is inclined by an angle within a range from 5° to 30° with respect to a face (a plane in one example) of the substrate 11 to exhaust surplus glass particulates 3 unattached onto the substrate 11. In this inclining state, the optical waveguide is formed on the substrate 11 while the surplus glass particulates 3 are exhausted by the exhaust pipe 1. The substrate 11 is set to a silicon substrate as one example.

An inclination angle of the side of the suction port 2 of the exhaust pipe 1 used at an exhausting time of the surplus glass particulates 3 is set to 10° in a first concrete example, and is set to 15° in a second concrete example. In each concrete example, an exhausting situation of the surplus glass particulates 3 is observed. Further, a position of the surplus glass particulates 3 deposited within the exhaust pipe 1, the dispersion width of a deposited film thickness distribution and the defect number are respectively calculated.

As a result, in each of the first and second concrete examples, floating of the surplus glass particulates 3 during the deposition can be restrained. Further, as shown in Table 1, the position of the surplus glass particulates 3 deposited within the exhaust pipe 1 can be located inside the exhaust pipe 1 in each concrete example although this position is located in the suction port 2 (inlet port of the exhaust pipe) of the exhaust pipe 1 in the conventional example. The defect number can be also greatly reduced in comparison with the conventional example so that yield of manufacture can be greatly improved.

**[Table 1]**

| | dispersion (µm) of film thickness distribution | defect of waveguide film | depositing position of particulates within exhaust pipe (inlet port of exhaust pipe is set to 0 cm) |
|---|---|---|---|
| first concrete example | 1.4 µm | 6 | 2.5 cm |
| second concrete example | 1.4 µm | 7 | 3.6 cm |
| conventional example | 1.6 µm | 13 | 0 cm |

In one embodiment of the invention, the glass particulates are deposited and the optical waveguide is formed on the basis of the consideration of the experimental results shown in Fig. 3, while the glass particulates 3 are exhausted in a state in which the side of the suction port 2 of the exhaust pipe 11 is inclined by an angle within a range from 5° to 30° with respect to the face of the substrate 11. Accordingly, as shown in each of the concrete examples 1 and 2, the flow of the surplus glass particulates 3 can be perfectly guided into the exhaust pipe 1. Further, in addition to this, the surplus glass particulates 3 guided into the exhaust pipe 1 can be deposited inside the exhaust pipe 1 so as not to drop these surplus glass particulates 3 onto a film being deposited.

Accordingly, in accordance with one embodiment of the invention, the optical waveguide having a waveguide construction as designed can be precisely manufactured by using the flame hydrolysis deposition method, and its manufacture yield can be improved.

The invention is not limited to the above embodiment, but various embodiment modes can be adopted. For example, in the above embodiment, the substrate 11 of the manufactured optical waveguide is formed by silicon. However, no material of the substrate 11 of the optical waveguide is particularly limited, but another material of the substrate may be also used. Similarly, no material of the optical waveguide of the lower clad, the core and the upper clad is limited to the above embodiment, but another material may be also suitably selected and set. Further, the exhaust pipe 1 may be formed in a cylindrical shape and a square sleeve shape, and may be also formed in another sectional shape if it can function as the exhaust pipe.

## Claims

1. A manufacturing method of an optical waveguide in which a hydrolysis reaction of raw material gas of glass is caused within an oxygen-hydrogen flame (5) by flowing said raw material gas, oxygen gas and hydrogen gas from a burner (6), and the optical waveguide is formed by depositing glass particulates on a substrate (11);
said manufacturing method comprising the steps of:
injecting said oxygen-hydrogen flame (5) toward an optical waveguide forming area in a slanting direction on said substrate (11);
arranging an exhaust pipe (1) on the discharging side of a flow injected to this optical waveguide forming area; and
depositing glass particulates in said optical waveguide forming area while surplus glass particulates (3) unattached to said optical waveguide forming area are sucked and exhausted by the exhaust pipe (1);
**characterised in that** the surplus glass particulates (3) are sucked and exhausted by said exhaust pipe by inclining a suction port (2) side of said exhaust pipe (1) by an angle within a range from 5° to 30° with respect to a face of said substrate (11).

## Patentansprüche

1. Herstellverfahren für einen Lichtwellenleiter, bei dem eine Hydrolysereaktion eines Rohmaterialgases für Glas innerhalb einer Sauerstoff-Wasserstoffflamme (5) bewirkt wird, indem das Rohmaterialgas, Sauerstoffgas und Wasserstoffgas von einem Brenner (6) strömt, und bei dem der Lichtwellenleiter durch Abscheiden von Glaspartikeln auf einem Substrat (11) gebildet wird;
wobei das Herstellverfahren die folgenden Schritte aufweist:
Einblasen der Sauerstoff-Wasserstoffflamme (5) in Richtung einer Lichtwellenleiter bildenden Fläche in einer schrägen Richtung auf dem Substrat (11);
Anordnen einer Abluftleitung (1) auf der Ableitseite einer Strömung, die dieser Lichtwellenleiter bildenden Fläche zugeführt wird, und
Abscheiden von Glaspartikeln in der Lichtwellenleiter bildenden Fläche, während überschüssige Glaspartikel (3), die nicht an der Lichtwellenleiter bildenden Fläche haften, über die Abluftleitung (1) abgesaugt und abgeleitet werden;
**dadurch gekennzeichnet, dass** die überschüssigen Glaspartikel (3) mittels der Abluftleitung abgesaugt und abgeleitet werden, indem eine Seite eines Saugstutzens (2) der Abluftleitung (1) in einem Winkel zwischen 5° und 30° bezüglich einer Fläche des Substrats (11) geneigt wird.

## Revendications

1. Procédé de fabrication d'un guide d'onde optique dans lequel une réaction d'hydrolyse d'une matière première gazeuse de verre est réalisée à l'intérieur d'une flamme d'oxygène et d'hydrogène (5), en faisant circuler ladite matière première gazeuse, l'oxygène gazeux et l'hydrogène gazeux à partir d'un brûleur (6), et le guide d'onde optique est formé par dépôt de particules de verre sur un substrat (11) ;
ledit procédé de fabrication comprenant les étapes consistant à :
- injecter ladite flamme d'oxygène et d'hydrogène (5) vers une zone de formation d'un guide d'onde optique selon une direction inclinée sur ledit substrat (11) ;
- disposer un tuyau d'échappement (1) sur le côté de décharge d'un écoulement injecté dans cette zone de formation d'un guide d'onde optique ; et
- déposer des particules de verre dans ladite zone de formation d'un guide d'onde optique alors que les particules de verre en surplus (3) non liées à ladite zone de formation d'un guide d'onde optique sont aspirées et évacuées par le tuyau d'échappement (1) ;
**caractérisé en ce que** les particules de verre en surplus (3) sont aspirées et évacuées par ledit tuyau d'échappement en inclinant un côté d'entrée d'aspiration (7) dudit tuyau d'échappement (1) d'un angle dans une gamme allant de 5° à 30° par rapport à une face dudit substrat (11).
